# EUROPEAN PATENT SPECIFICATION

(11) **EP 0 285 298 B1**
(45) Date of publication and mention of the grant of the patent: **25.05.1994**
(21) Application number: 88302430.9
(22) Date of filing: 18.03.1988
(51) Int. Cl.: H01L 39/24, C04B 41/87

(54) **A method of manufacturing a conductive or superconductive thin film**
Verfahren zur Darstellung von leitenden oder supraleitenden dünnen Schichten
Procédé de fabrication d'un film mince conducteur ou supraconducteur

(30) Priority: 20.03.1987 JP 64288/87
(43) Date of publication of application: 05.10.1988
(73) Proprietor: Koinuma, Hideomi, Suginami-Ku Tokyo (JP); SEMICONDUCTOR ENERGY LABORATORY CO., LTD., Atsugi-shi Kanagawa-ken, 243 (JP)
(72) Inventor: Koinuma, Hideomi, Suginami-ku Tokyo (JP); Hashimoto, Takuya, Narashino-shi Chiba (JP); Fueki, Kazuo, Setagaya-ku Tokyo (JP)
(74) Representative: Milhench, Howard Leslie

(56) References cited:
- EP-A- 0 022 279
- CHEMICAL ABSTRACTS, vol. 100, no. 20, 14th May 1984, page 572, no. 165516u, Columbus, Ohio, US; & JP-A-58 27 389
- ZEITSCHRIFT FÜR PHYSIK B-CONDENSED MATTER, vol. 64, no. 2, 1986, pages 189-193, Springer-Verlag; J.G. BEDNORZ et al.: "Possible high Tc superconductivity in the Ba-La-Cu-O system"

## Description

### FIELD OF THE INVENTION

The present invention relates to a method of manufacturing a superconductive thin film, and to a thin film manufactured by the said method.

### BACKGROUND OF THE INVENTION

Conductive materials are used for varistors, sensors, and the like, while superconductive materials are also used for coils and conductive wires (which otherwise show large electrical power losses), for Josephson elements or magnetic shield material, and the like, because they demonstrate zero electrical resistance, the Josephson effect, and full diamagnetic characteristics and the like.

Superconductive materials such as niobium-tin alloys (which have a critical temperature of 18°K), niobium-germanium alloys (which have a critical temperature of 23 K) and the like have long been known. The possibility of manufacturing superconductive bodies with high critical temperatures from complex copper oxides such as (La₁₋ₓBaₓ)₂Cu0₄ was suggested by Bednor and Miller in 1986. Uchida et al confirmed in 1986 that these compounds had a higher critical temperature of about 30 K which had not previously been experienced. Since then, active research has been carried out on these and similar materials.

It was discovered by Kisio et al in 1986 that the composition (La_{0.9}Sr_{0.1})₂Cu0₄ had a relatively high critical temperature of 37 K. Further, Professor Chu of Houston University and his colleagues discovered in 1986 complex oxide superconductive materials having high transition temperatures of 98 K, exceeding the temperature of liquid nitrogen. In particular, considerable interest has been generated in superconductive materials of a composition which can be represented by the general formula: (La₁₋ₓMₓ)_{y}Cu0_{4-δ}, where M is an alkaline earth metal or a mixture of such alkaline earth metals; 0<x<1, y=1.5 to 2.5; and δ=0 to 1; or by the general formula: (N₁₋ₓMₓ)ₚCu_{q}0_{7-δ} where N is Sc, Y, or a lanthanide; M is an alkaline earth metal or a mixture of such alkaline earth metals, 0<x<1, p=2.5 to 3.5, q=1.5 to 3.5, and δ=0 to 1.

However, this type of complex copper oxide superconductive material is a variety of ceramic which has hitherto been obtainable only in powder form or as a fired body in bulk form, the fired body being obtained by using the powder as a raw material and, after forming the powder into a bulk body under pressure, providing heat treatment at high temperature to consolidate the powder. For this reason, it has not been possible as a practical matter to use such complex copper oxide superconductive materials to form a Josephson high speed switching element for example, or an elongate conductor for use in various types of devices where it is necessary to provide the material in film form.

Chemical Abstracts, Vol. 100, No. 20, page 572, 165516u describes a method of producing a thin film pattern of metals, semiconductors, metal oxides, etc. by printing on a substrate a paste containing a binder and fine particles dispersed in a solvent, evaporating the solvent and nearly burning off the binder on the printed paste to leave a pattern of fine particles on the substrate, forming on the upper surface a thin film, and then removing the fine particles and the thin film thereabove to form a film pattern.

### SUMMARY OF THE INVENTION

In accordance with the present invention, a method of producing a complex copper oxide superconductive film comprises: providing a complex copper oxide superconductive material in powder form; adding an organic solvent binder to the powdered superconductive material thereby to produce a paste; printing said paste in a film on a substrate; drying and firing the paste on the substrate to form a consolidated film; and effecting thermal annealing of the consolidated film.

The present invention thus provides a method of manufacturing superconductive films, using the above-mentioned complex copper oxide superconductive materials as a starting material, so that the advantageous properties of such superconductive complex copper oxide materials can properly be utilized. The method of the invention employs printing, drying and firing steps to form a consolidated film which is then annealed, and it has been found that the superconductivity of the starting material is maintained after the film is formed. The invention thus enables superconductive films to be produced and enables superconductive complex copper oxide materials to be more widely utilized.

Further features of the present invention are set forth in the appended claims and will become more apparent from consideration of the following description of exemplary embodiments given in conjunction with the accompanying drawing.

### BRIEF DESCRIPTION OF THE DRAWING

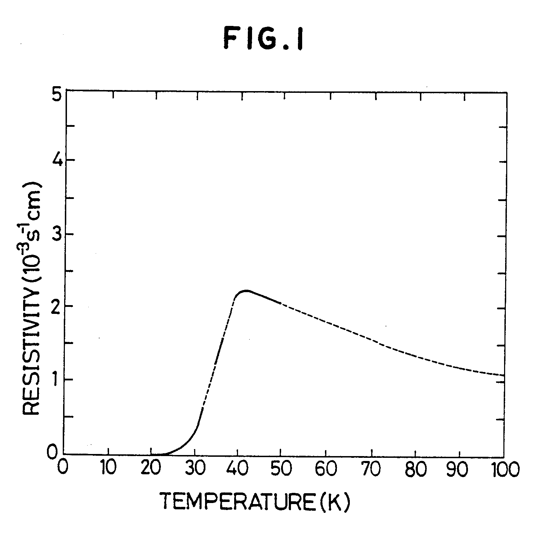

Fig.1 is a graph showing the results of measurements of the electrical resistivity at low temperature of an exemplary thin film manufactured in accordance with the teachings of the present invention.

### DETAILED DESCRIPTION OF THE EMBODIMENTS

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa,, IVa, Va, VIa and VIIa of the European Periodic Table.

A preferred embodiment of the present invention comprises a method of manufacturing a superconductive thin film wherein an organic solvent binder is added to powdered superconductive complex copper oxide material to form a paste which is kneaded, and then screen printed onto a substrate, then dried, fired and annealed.

As the superconductive complex copper oxide material, many compositions can be used. For example, one type of complex copper oxide material which can be used has a composition represented by the general formula: (La₁₋ₓMₓ)_{y}Cu0_{4-δ}, where M is a member selected from the group of alkaline earth metals and mixtures of the alkaline earth metals, 0<x<1, y=1.5 to 2.5, and δ=0 to 1; and another type of complex copper oxide material that can be used has a composition represented by the general formula: (N₁₋ₓMₓ)ₚCu_{q}0_{7-δ} where N is an element selected from the group comprising Sc, Y and the lanthanides; M is a member selected from the group of alkaline earth metals and mixtures of the alkaline earth metals; 0<x<1, p=2.5 to 3.5, q=1.5 to 3.5, and δ=0 to 1.

As the organic solvent binder which is added to the complex copper oxide material and then kneaded to form a paste, solvents with a boiling point of 150°C to 200°C are preferably used, since they are easy to dry, have a certain degree of viscosity, and are easily printed. For example, octyl alcohol, propylene glycol, heptyl alcohol, and the like can be preferably used.

As a substrate, a material such as quartz, alumina, zirconia, or La₂Cu0₄ for example which does not react with the superconductive complex copper oxide material and can withstand the firing temperature, can be used.

As a means for screen printing, any commercially available screen printing machine may be used, employing any usual methods.

A suitable temperature range for firing the material is 700°C to 1000°C.

### Example

After slurrying La₂0₃, SrC0₃ and Cu0 in prescribed proportions in ethanol, the mixture was fired at 900°C for 16 hours.

The resulting (La_{0.9}Sr_{0.1})₂Cu0_{4-δ} was then powdered, and 0.8ml of heptyl alcohol was added to 2 grams of this powder and mixed into a paste.

The resulting (La_{0.9}Sr_{0.1})₂Cu0_{4-δ} paste was screen printed onto an La₂Cu0₄ substrate using a commercially available screen printing machine, and after drying under vacuum for 6 hours at 150°C, was fired at 1000°C for 10 minutes. It was then annealed at 500°C for 10 hours. The thickness of the resulting film was gravimetrically determined from weight increase to be 15 to 20µm.

The electrical resistivity of the thin film formed in this manner was found to suddenly decrease at 43 K and become zero at 25°K.

As a comparative exercise, the foregoing procedure was carried out but with the annealing step omitted. The electrical resistivity of the film was seen to suddenly decrease at 42 K and became zero at 8 K. The significance of the annealing step is thus clear.

Fig.1 is a graph showing the result of measurements made of the electrical resistivity at low temperatures of a film made in accordance with the above example, wherein the ordinate indicates the electrical resistivity in 10⁻³S⁻¹cm while the abscissa indicates the absolute temperature in K.

In the practice of the present invention, other types of compositions can be used as the superconductive complex copper oxide ceramic material. For example, the superconductive complex copper oxide ceramic material may be consistent with the stoichiometric formula (A₁₋ₓBₓ)_{y}Cu_{z}0₂0_{w}, where A is one or more elements of Group IIIa of the Japanese Periodic Table, e.g. the rare earth elements, B is one or more elements of Group IIa of the Japanese Periodic Table, e.g. the alkaline earth metals including beryllium and magnesium, and 0<x<1; y=2.0 to 4.0, preferably 2.5 to 3.5; z=1.0 to 4.0, preferably 1.5 to 3.5; and w=4.0 to 10.0, preferably 6.0 to 8.0. Also, superconductive complex copper oxide ceramics for use in accordance with the present invention may be consistent with the stoichiometric formula (A₁₋ₓBₓ)_{y}Cu_{z}0_{w}, where A is one or more elements of Group Vb of the Japanese Periodic Table such as Bi, Sb and As, B is one or more elements of Group IIa of the Japanese Periodic Table, e.g. the alkaline earth metals including beryllium and magnesium, and 0<x<1; y=2.0 to 4.0, preferably 2.5 to 3.5; z=1.0 to 4.0, preferably 1.5 to 3.5; and w=4.0 to 10.0, preferably 6.0 to 8.0. One example of the former formula is YBa₂Cu₃0ₓ (x=6 to 8), and examples of the latter formula re BiSrCaCu₂0ₓ and Bi₄Sr₃Ca₃Cu₄0ₓ. In addition, the composition Bi₄(Sr_{y}Ca₂)Cu₄0ₓ may be utilized for the purposes of the invention and its Tc is 40 to 60 K when the value of y is about 1.5. The Tc onset and Tco of the composition Bi₄Sr₄Ca₂Cu₄0ₓ is 110 K and 79 K, respectively. The value of x in the above formulae is estimated to be 6 to 10, for example about 8.1.

The stoichiometric formulae mentioned above can be determined for example by X-ray diffraction.

## Claims

1. A method of producing a complex copper oxide superconductive film, said method comprising:
providing a complex copper oxide superconductive material in powder form;
adding an organic solvent binder to the powdered superconductive material thereby to produce a paste;
printing said paste in a film on a substrate;
drying and firing the paste on the substrate to form a consolidated film; and
effecting thermal annealing of the consolidated film.

2. A method as claimed in claim 1, wherein the firing of the paste is effected at a temperature in the range of 700-1000°C.

3. A method as claimed in claim 2, wherein the thermal annealing of the consolidated film is effected at 500°C.

4. A method as claimed in any preceding claim, wherein the organic solvent binder comprises octyl alcohol, propylene glycol, or heptyl alcohol.

5. A method as claimed in any preceding claim, wherein said substrate comprises quartz, alumina, zirconia, or La₂CuO₄.

6. A method as claimed in any preceding claim, wherein said complex copper oxide superconductive material is represented by the general formula: (La₁₋ₓMₓ)_{y}CuO_{4-δ}, where M is an alkaline earth metal or a mixture of alkaline earth metals, 0<x<1, y=1.5 to 2.5 and δ=0 to 1.

7. A method as claimed in claim 6 wherein said complex copper oxide superconductive material is (La_{0.9}Sr_{0.1})₂Cu0_{4-δ}.

8. A method as claimed in any of claims 1 to 5, wherein said complex copper oxide superconductive material is represented by the general formula: (N₁₋ₓMₓ)ₚCu_{q}0_{7-δ} where N is an element selected from the group comprising Sc, Y and the lanthanides; M is an alkaline earth metal or a mixture of alkaline earth metals; 0<x<1, p=2.5 to 3.5, q=1.5 to 3.5, and δ=0 to 1.

9. A method as claimed in claim 8 wherein N is Y, M is Ba and the Y:Ba:Cu stoichiometric ratio is 1:2:3.

10. A method as claimed in any of claims 1 to 5, wherein said complex copper oxide superconductive material is represented by the general formula: (A₁₋ₓBₓ)_{y}Cu_{z}0_{w}, where A is at least one element of Group Vb of the Japanese Periodic Table; B is at least one element of Group IIa of the Japanese Periodic Table; and 0<x<1; y=2.0 to 4.0; z=1.0 to 4.0; and w=4.0 to 10.0.

11. A method as claimed in any preceding claim, wherein the printing of the paste onto the substrate is effected by screen printing.

## Patentansprüche

1. Verfahren zum Herstellen eines supraleitenden Films aus einem komplexen Kupferoxid, welches Verfahren folgendes aufweist:
- Bereitstellen eines supraleitenden, komplexen Kupferoxidmaterials in Pulverform;
- Zugeben eines Bindemittels in Form eines organischen Lösungsmittels zum pulverisierten supraleitenden Material, um dadurch eine Paste herzustellen;
- Aufdrucken der Paste als Film auf ein Substrat;
- Trocknen und Brennen der Paste auf dem Substrat, um einen verdichteten Film herzustellen; und
- thermisches Tempern des verdichteten Films.

2. Verfahren nach Anspruch 1, bei dem das Brennen der Paste bei einer Temperatur im Bereich von 700 - 1000°C ausgeführt wird.

3. Verfahren nach Anspruch 2, bei dem das thermische Tempern des verdichteten Films bei 500°C ausgeführt wird.

4. Verfahren nach einem der vorstehenden Ansprüche, bei dem das Bindemittel in Form eines organischen Lösungsmittels Octylalkohol, Propylenglycol oder Heptylalkohol ist.

5. Verfahren nach einem der vorstehenden Ansprüche, **dadurch gekennzeichnet**, daß das Substrat aus Quarz, Aluminiumoxid, Zirkoniumdioxid oder La₂CuO₄ besteht.

6. Verfahren nach einem der vorstehenden Ansprüche, bei dem das supraleitende, komplexe Kupferoxidmaterial durch die allgemeine Formel (La₁₋ₓMₓ)_{y}CuO_{4-δ} wiedergegeben wird, wobei M ein Erdalkalimetall oder eine Mischung von Erdalkalimetallen ist und 0 < x < 1, y = 1,5 bis 2,5 und δ = 0 bis 1 sind.

7. Verfahren nach Anspruch 6, bei dem das supraleitende Material in Form eines komplexen Kupferoxids (La_{0,9}Sr_{0,1})₂Cu_{4-δ} ist.

8. Verfahren nach einem der Ansprüche 1 bis 5, bei dem das supraleitende, komplexe Kupferoxidmaterial durch die allgemeine Formel (N₁₋ₓMₓ)ₚCu_{q}O_{7-δ} wiedergegeben wird, wobei N ein aus der Sc, Y und die Lanthanide umfassenden Gruppe ausgewähltes Element ist, M ein Erdalkalimetall oder eine Mischung von Erdalkalimetallen ist, und 0 < x < 1, p = 2,5 bis 3,5, q = 1,5 bis 3,5 und δ = 0 bis 1 sind.

9. Verfahren nach Anspruch 8, bei dem N Y ist, M Ba ist und das stöchiometrische Verhältnis von Y:Ba:Cu 1:2:3 ist.

10. Verfahren nach einem der Ansprüche 1 bis 5, bei dem das supraleitende, komplexe Kupferoxidmaterial durch die allgemeine Formel (A₁₋ₓBₓ)_{y}Cu_{z}O_{w} wiedergegeben wird, wobei A mindestens ein Element aus der Gruppe Vb des japanischen Periodensystems ist, B mindestens ein Element aus der Gruppe IIa des japanischen Periodensystems und 0 < x < 1, y = 2,0 bis 4,0; z = 1,0 bis 4,0 und w = 4,0 bis 10,0 sind.

11. Verfahren nach einem der vorstehenden Ansprüche, bei dem das Aufdrucken der Paste auf das Substrat durch Siebdrucken erfolgt.

## Revendications

1. Procédé de production d'un film supraconducteur d'oxyde de cuivre complexe, ledit procédé comprenant :
la mise en oeuvre d'un matériau supraconducteur d'oxyde de cuivre complexe sous forme pulvérulente,
l'addition d'un liant solvant organique au matériau supraconducteur pulvérulent de manière à produire une pâte,
l'impression de ladite pâte sous la forme d'un film sur un substrat,
le séchage et la calcination de la pâte sur le substrat pour former un film consolidé, et
le recuit thermique du film consolidé.

2. Procédé selon la revendication 1, dans lequel la calcination de la pâte est effectuée à une température dans la plage de 700 à 1000°C.

3. Procédé selon la revendication 2, dans lequel le recuit thermique du film consolidé est effectué à 500°C.

4. Procédé selon l'une quelconque des revendications précédentes, dans lequel le liant solvant organique comprend l'alcool octylique, le propylène glycol ou l'alcool heptilique.

5. Procédé selon l'une quelconque des revendications précédentes, dans lequel ledit substrat comprend le quartz, l'alumine, l'oxyde de zirconium ou le La₂CuO₄.

6. Procédé selon l'une quelconque des revendications précédentes, dans lequel ledit matériau supraconducteur d'oxyde de cuivre est représenté par la formule générale (La₁₋ₓMₓ)_{y}CuO_{4-δ}, dans laquelle M est un métal alcalino-terreux ou un mélange de métaux alcalino-terreux, 0<x<1, y=1,5 à 2,5 et δ=0 à 1.

7. Procédé selon la revendication 6, dans lequel ledit matériau supraconducteur d'oxyde de cuivre complexe est le (La_{0,9}Sr_{0,1})₂CuO_{4-δ}.

8. Procédé selon l'une quelconque des revendications 1 à 5, dans lequel ledit matériau supraconducteur d'oxyde de cuivre complexe est représenté par la formule générale (N₁₋ₓMₓ)ₚCu_{q}O_{7-δ} dans laquelle N est un élément choisi dans le groupe comprenant Sc, Y et les lanthanides, M est un métal alcalino-terreux ou un mélange de métaux alcalino-terreux, 0<x<1, p=2,5 à 3,5, q=1,5 à 3,5 et δ=0 à 1.

9. Procédé selon la revendication 8, dans lequel N est Y, M est Ba et le rapport stoéchiométrique Y:Ba:Cu est de 1:2:3.

10. Procédé selon l'une quelconque des revendications 1 à 5, dans lequel ledit matériau supraconducteur d' oxyde de cuivre complexe est représenté par la formule générale (A₁₋ₓBₓ)_{y}Cu_{z}O_{w}, dans laquelle A est au moins un élément du groupe Vb du Tableau Périodique japonais, B est au moins un élément du groupe IIa du Tableau Périodique japonais et 0<x<1, y=2,0 à 4,0, z=1,0 à 4,0 et w=4,0 à 10,0.

11. Procédé selon l'une quelconque des revendications précédentes, dans lequel l'impression de la pâte sur le substrat est réalisée par sérigraphie.
